# FASCICULE DE BREVET EUROPEEN

(11) **EP 0 462 029 B1**
(45) Date de publication et mention de la délivrance du brevet: **09.08.1995**
(21) Numéro de dépôt: 91420183.5
(22) Date de dépôt: 07.06.1991
(51) Int. Cl.: H01L 29/08, H01L 27/06

(54) **Procédé de fabrication d'un transistor bipolaire supportant des polarisations inverses**
Herstellungsverfahren eines Bipolartransistors, der umgekehrten Vorspannungen standhält
Process of fabricating a bipolar transistor sustaining a reverse bias

(30) Priorité: 11.06.1990 FR 9007459
(43) Date de publication de la demande: 18.12.1991
(73) Titulaire: SGS-THOMSON MICROELECTRONICS S.A., 94250 Gentilly (FR)
(72) Inventeur: Jimenez, Jean, F-38500 Voiron (FR)
(74) Mandataire: de Beaumont, Michel

(56) Documents cités:
- EP-A- 0 241 699
- EP-A- 0 378 164
- IBM TECHNICAL DISCLOSURE BULLETIN. vol. 21, no. 3, août 1979, NEW YORK US pages 1023 - 1024; C.H.Lee: "Bipolar Transistor"
- Proceedings of the 1989 Bipolar Circuits and Technology Meeting Sept.18-19,1989,IEEE,Minneapolis,USA pages 178 - 181; H.Klose et al.: "Lost Cost and High Performance BICMOS Processes: A Comparison"

## Description

La présente invention concerne le domaine des circuits intégrés et plus particulièrement des circuits intégrés fabriqués selon des technologies permettant de former sur une même puce des transistors de type bipolaire et des transistors de type MOS. Une telle technologie sera appelée ci-après technologie BICMOS (BIpolaire Complémentaire MOS) pour indiquer qu'il peut exister dans une même puce des transistors bipolaires et des transistors MOS complémentaires.

Dans le cadre de ces technologies, la présente invention vise à résoudre le problème posé par la dégradation du gain des transistors bipolaires soumis, du fait de leur position dans un montage électrique, à des polarisations base-émetteur inversées répétitives.

Un procédé selon l'invention est défini dans la revendication unique ci-jointe.

Pour atteindre cet objet, la présente invention prévoit, dans un circuit intégré BICMOS, de fabriquer certains au moins des transistors bipolaires en utilisant, pour former la jonction d'émetteur, des technologies à espaceurs similaires à celles utilisées pour former des drains et sources des transistors MOS du même circuit.

Une structre semblable à celle à laquelle on arrive selon la présente invention est décrite dans EP-A-0378164 qui est opposable seulement au titre des articles 54 (3 et 4) de la CBE et qui désigne la France, l'Allemagne et la Grande-Bretagne.

Une autre structure similaire est décrite dans IBM Technical Disclosure Bulletin, Vol. 21, N° 3, pp. 1023-1024, août 1978.

Le problème que vise à résoudre la présente invention et un exemple de mise en oeuvre de la présente invention vont maintenant être exposés en relation avec les figures jointes parmi lesquelles :
la figure 1 représente un inverseur constitué à partir de transistors MOS et bipolaires ;
la figure 2 illustre un aspect classique de la technologie BICMOS ; et
les figures 3A et 3B illustrent les étapes particulières de fabrication d'un transistor bipolaire selon la présente invention.

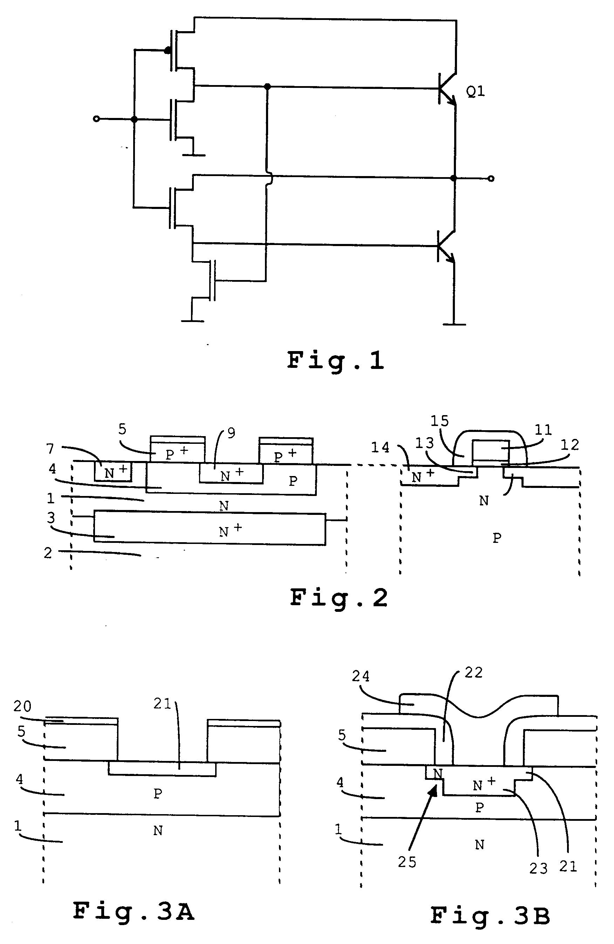

La figure 1 représente un inverseur en technologie BICMOS tel qu'illustré par exemple dans l'article de S.P. Joshi et al. paru dans IEDM 1987 pages 183-185.

Le contenu de cet article sera considéré comme connu et comme faisant partie de la présente description. Le schéma de la figure 1 ne sera donc pas décrit en détail. On notera seulement que l'inverseur illustré comprend des transistors MOS à canal N et à canal P et des transistors bipolaires. Comme cela est expliqué dans cet article, le transistor bipolaire Q1 va, lors de commutations de l'inverseur subir des phases de polarisation inverses de sa jonction émetteur/base. Il en résulte une dégradation du gain en tension de ce transistor bipolaire.

L'article susmentionné a pour but non pas de remédier à cet inconvénient mais d'analyser ses causes et de permettre de prédire la durée de vie du transistor Q1.

Cet article indique que le phénomène susmentionné de dégradation de durée de vie des transistors bipolaires soumis à des polarisations émetteur-base inverses est particulièrement sensible dans les circuits intégrés de type BICMOS et notamment dans le cas où les bases et émetteurs des transistors bipolaires sont formés à partir de couches de silicium polycristallin fortement dopées.

La figure 2 représente de façon extrêmement schématique une vue en coupe d'une portion de circuit intégré BICMOS comprenant dans sa partie gauche un transistor bipolaire NPN et dans sa partie droite un transistor MOS à canal N. Le transistor bipolaire est formé dans un caisson de collecteur 1 de type N lui-même formé sur un substrat 2 de type P avec interposition éventuelle d'une couche enterrée 3. Dans ce caisson, est formée une région de base 4 sur laquelle des contacts sont pris à partir d'une portion d'une couche de silicium polycristallin 5, correspondant dans la technologie de fabrication à un premier niveau de silicium polycristallin fortement dopé de type P également utilisé pour former la grille des transistors MOS. Un contact est pris sur la région de collecteur par l'intermédiaire d'une région 7 surdopée de type N⁺, cette région étant recouverte, pour la reprise de contact d'un deuxième niveau de silicium polycristallin fortement dopé de type N (non représenté), ce deuxième niveau de silicium polycristallin étant également utilisé pour former des contacts avec des régions d'émetteur 9 de type N⁺ implantées dans les régions de base 4.

Dans la partie droite de la figure est représenté un transistor MOS à canal N formé dans une région P correspondant au substrat 2 ou à un caisson ménagé dans ce substrat. La grille 11 de ce transistor MOS correspond au même niveau de silicium polycristallin que celui des régions désignées par la référence 5. Cette grille est formée classiquement sur une couche d'oxyde mince 12 et les diffusions de drain et de source ont une structure dite LDD (Low Doped Drain), c'est-à-dire qu'elles comprennent une région 13 de type N faiblement dopée pénétrant légèrement sous la grille, formée en utilisant comme masque la grille 11, et une région 14 plus fortement dopée et distante de la région de grille. Ces régions N⁺ sont formées en utilisant comme masque la grille 11 élargie par des espaceurs d'oxyde 15. Une structure de ce type se voit notamment dans la figure 2 de l'article cité ci-dessus.

La présente invention propose, pour éviter le problème de dégradation du gain des transistors bipolaires soumis à des tensions émetteur-base inverses, d'adopter pour l'émetteur une structure similaire à la structure LDD des transistors MOS.

La formation des régions d'émetteur des transistors bipolaires selon la présente invention est illustrée schématiquement en figures 3A et 3B.

En figure 3A, on peut voir une partie de région de base 4 superposée à une région de collecteur 1. Sur la région de base sont formées des régions 5 de type P⁺ correspondant au premier niveau de silicium polycristallin, comme cela a été exposé précédemment. Dans une ouverture formée dans le silicium polycristallin 5 (éventuellement surmontée d'une couche d'oxyde de silicium 20 et d'une couche de résine), on forme une implantation ou une diffusion 21 de type N à faible niveau de dopage. Cette région 21 est formée en même temps que les régions 13 illustrées en figure 2 et n'implique donc pas d'étape de fabrication supplémentaire.

Ensuite, comme le représente la figure 3B, on forme des espaceurs 22 de part et d'autre de l'ouverture dans la couche de silicium polycristallin 5. Ces espaceurs sont formés en même temps que les espaceurs 15 de la figure 2. Puis l'on forme une implantation de type N⁺ d'émetteur 23, en même temps que les implantations de drain et de source. Après quoi, comme cela est classique, les régions d'émetteur sont surmontées d'une couche conductrice 24 correspondant, par exemple, à une portion du deuxième niveau de silicium polycristallin.

Grâce à la présente invention, on évite les problèmes de dégradation du gain en tension des transistors bipolaires car l'émission de porteurs chauds au lieu de se produire au voisinage de la surface supérieure de la couche de base 4 se forme maintenant à l'interface entre cette couche de base 4 et les parties latérales 25 de la région 23 de type N plus fortement dopées. Les porteurs chauds formés à cette interface ne peuvent atteindre la surface supérieure des couches 4, 21, 23 et il n'y a plus de problème de piégeage aux interfaces silicium-oxyde.

Ainsi, selon la présente invention, on a résolu de façon particulièrement simple le problème de la dégradation du gain des transistors bipolaires par suite de polarisations inverses alors que, dans l'art antérieur, on s'était contenté de constater ce problème, et de l'étudier pour mieux en prédire les effets. De plus, la présente invention permet de résoudre le problème posé en utilisant des moyens technologiques qui étaient tous déjà connus et qui sont particulièrement simples et ne compliquent pas la fabrication d'un circuit intégré BICMOS.

L'adoption selon la présente invention de structures de type LDD pour les transistors bipolaires pourrait être considérée comme présentant certains inconvénients, mais ces inconvénients ne sont qu'apparents.

D'une part, alors que pour les transmissions MOS l'adoption d'une structure de type LDD permet de réduire la capacité grille/drain-source, dans un transistor bipolaire, l'adoption de la structure illustrée en figure 3B augmente la capacité émetteur-base. Toutefois, dans l'application considérée en figure 1, cette augmentation de capacité est peu gênante car la résistance dynamique d'émetteur est faible et donc, même si la capacité émetteur-base augmente, la constante de temps de commutation restera faible.

Un autre inconvénient de la structure selon la présente invention est que l'on augmente la résistance série de base et notamment la résistance de base intrinsèque qui est la composante la plus importante de la résistance de base. A nouveau, cette augmentation de la résistance de base est sans effet pratique gênant dans un montage du type de celui de la figure 1.

La présente invention a été décrite précédemment de façon très schématique en relation avec une technologie de fabrication elle-même décrite très schématiquement. En effet, ces technologies sont connues de l'homme de l'art qui saura y apporter diverses variantes et adapter la présente invention à la technologie particulière qu'il utilise.

## Revendications

1. Procédé de fabrication d'un circuit intégré comprenant des transistors bipolaires et des transistors MOS, la région d'émetteur d'au moins un transistor bipolaire comprenant une région (21) à faible niveau de dopage à l'intérieur de laquelle est formée une région (23) à plus fort niveau de dopage, caractérisé en ce que :
la région (21) à faible niveau de dopage est formée par implantation dans les ouvertures d'un masque constituées d'un premier niveau de silicium polycristallin, en même temps qu'est réalisée une implantation à faible niveau de dopage de part et d'autre des grilles des transistors MOS, et
la région (23) à plus fort niveau de dopage est réalisée, en même temps que les drains et sources des transistors MOS, en formant d'abord des espaceurs (22) de part et d'autre des grilles des transistors MOS et à l'intérieur des ouvertures définies dans le masque d'émetteur, puis en réalisant une implantation à plus fort niveau de dopage limitée par ces espaceurs.

## Patentansprüche

1. Verfahren zur Herstellung einer integrierten Schaltung, welche Bipolartransistoren und MOS-Transistoren enthält, wobei der Emitterbereich mindestens eines Bipolartransistors einen Bereich (21) mit einem geringen Dotierungsniveau enthält, innerhalb dessen ein Bereich (23) mit einem höheren Dotierungniveau ausgebildet ist,
dadurch gekennzeichnet, daß
der Bereich (21) mit einem geringen Dotierungsniveau durch Implantation in den Öffnungen einer Maske, welche durch ein erstes Niveau aus polykristallinem Silicium gebildet werden, zur gleichen Zeit gebildet wird, wie eine Implantation mit einem geringen Dotierungsniveau auf beiden Seiten der Gates der MOS-Transistoren realisiert wird, und
der Bereich (23) mit einem höheren Dotierungsniveau gleichzeitig mit den Drains und Sources der MOS-Transistoren realisiert wird, indem zunächst Abstandshalter (22) auf beiden Seiten der Gates der MOS-Transistoren und innerhalb der in der Emittermaske festgelegten Öffnungen gebildet werden und danach eine Implantation mit einem höheren Dotierungsniveau realisiert wird, welche durch diese Abstandshalter begrenzt wird.

## Claims

1. A method for manufacturing an integrated circuit comprising bipolar transistors and MOS transistors, the emitter region of at least one bipolar transistor comprising a lower doped region (21) inside which is formed a higher doped region (23), characterized in that:
said lower doped region (21) is formed through dopant implantation in mask apertures formed by a first polysilicon level, simultaneously with a low doped implantation on both sides of the gates of the corresponding MOS transistors,
said higher doped region (23) is formed, simultaneously with the drains and sources of the corresponding MOS transistors, firstly by forming spacers (22) on both sides of the MOS transistor gates and inside the apertures defined in the emitter mask, then by implanting a dopant at a high doping level in the region limited by these spacers.
